# EUROPÄISCHE PATENTSCHRIFT

(11) **EP 0 772 223 B1**
(45) Veröffentlichungstag und Bekanntmachung des Hinweises auf die Patenterteilung: **03.01.2007**
(21) Anmeldenummer: 96111817.1
(22) Anmeldetag: 23.07.1996
(51) Int. Cl.: H01J 37/34

(54) **Vorrichtung zum Beschichten eines Substrats von elektrisch leitfähigen Targets**
Device for coating a substrate from electrically conductive targets
Dispositif pour revêtir un substrat à partir de cibles conductrices d'électricité

(30) Priorität: 02.11.1995 DE 19540794
(43) Veröffentlichungstag der Anmeldung: 07.05.1997
(73) Patentinhaber: Oerlikon Deutschland Holding GmbH, 80331 München (DE)
(72) Erfinder: Szczyrbowski, Joachim, Dr., 63773 Goldbach (DE); Teschner, Götz, 63450 Hanau (DE); Bräuer, Günter, Dr., 63579 Freigericht-Altenmittlau (DE)

(56) Entgegenhaltungen:
- DE-A- 3 541 621
- DE-A- 3 802 852
- DE-A- 4 106 770
- DE-A- 4 204 999
- TISONE T.C., BINDELL J.B.: J. OF VACUUM SCIENCE AND TECHNOLOGY, Bd. 11, Nr. 2, 1974, Seiten 519-527, XP008034347

## Beschreibung

Die Erfindung betrifft eine Vorrichtung zum Beschichten eines Substrats von einem elektrisch leitfähigen Target, umfassend eine Wechselstromquelle, die mit zwei Magnetron-Kathoden verbunden ist, die elektrisch mit den Targets zusammenwirken, wobei der eine Pol der Wechselstromquelle an die eine Kathode und der andere Pol an die andere Kathode über Versorgungsleitungen angeschlossen ist.

Bekannt ist eine Sputteranordnung, die als Triodenanordnung bezeichnet wird (low-voltage triode sputtering with a confined plasma; T. C. Tisone a. J. B. Bindell, J. of Vacuum Science a. Technology, Vol. 11, 1974, Seiten 519 bis 527), bei der das Plasma vor dem abzusputternden Target durch den Einsatz einer zusätzlichen Niedervolt-Gasentladung mit einer thermischen Kathode als Elektronenquelle verstärkt wird. Die Elektronen fließen in diesem Falle quer durch das Hauptentladungsplasma, wodurch die Ladungsträgerdichte erhöht und die Gasionisation verstärkt wird. Diese bekannte Vorrichtung hat jedoch den Nachteil, daß die mögliche Stromdichte begrenzt ist und insbesondere eine schlechte Langzeitstabilität aufweist.

Es ist auch eine Zerstäubungseinrichtung zur Herstellung dünner Schichten bekannt (DD 252 205), bestehend aus einem Magnetsystem und mindestens zwei darüber angeordneten Elektroden aus dem zu zerstäubenden Material, wobei diese Elektroden elektrisch so gestaltet sind, daß sie wechselweise Kathode und Anode einer Gasentladung sind. Die Elektroden sind zu diesem Zwecke an eine sinusförmige Wechselspannung von vorzugweise 50 Hz angeschlossen.

Diese bekannte Zerstäubungseinrichtung soll besonders für die Abscheidung dielektrischer Schichten durch reaktive Zerstäubung geeignet sein. Durch den Betrieb der Einrichtung mit etwa 50 Hz soll vermieden werden, daß es zur Flitterbildung an der Anode und im Falle von Metallbeschichtung zu elektrischen Kurzschlüssen (sogenannten Arcs) kommt.

Bei einer anderen bereits bekannten Vorrichtung zum Aufstäuben eines dünnen Films, bei der die Geschwindigkeit des Niederbringens von Schichten unterschiedlicher Materialien regelbar ist (DE 39 12 572), um so zu extrem dünnen Schichtpaketen zu gelangen, sind mindestens zwei unterschiedliche Arten von kathodenseitig vorgesehenen Gegenelektroden angeordnet.

Weiterhin ist eine Anordnung zum Abscheiden einer Metalllegierung mit Hilfe von HF-Kathodenzerstäubung bekannt (DE 35 41 621), bei der abwechselnd zwei Targets angesteuert werden, wobei die Targets die Metallkomponenten der abzuscheidenden Metallegierung jedoch mit unterschiedlichen Anteilen enthalten. Die Substrate sind zu diesem Zweck auf einem Substratträger angeordnet, der von einer Antriebseinheit während des Zerstäubungsvorgangs in Rotation versetzt wird.

Durch eine vorveröffentlichte Druckschrift (DE 38 02 852) ist es außerdem bekannt, bei einer Einrichtung für die Beschichtung eines Substrats mit zwei Elektroden und wenigstens einem zu zerstäubenden Material das zu beschichtende Substrat zwischen den beiden Elektroden in einem räumlichen Abstand anzuordnen und die Wechselstrom-Halbwellen als niederfrequente Halbwellen mit im wesentlichen gleichen Amplituden zu wählen.

Weiterhin sind ein Verfahren und eine Vorrichtung beschrieben (DE 41 06 770) zum reaktiven Beschichten eines Substrats mit einem elektrisch isolierenden Werkstoff, beispielsweise mit Siliziumdioxid (SiO₂) bestehend aus einer Wechselstromquelle, die mit in einer Beschichtungskammer angeordneten Magnete einschließende Kathoden verbunden ist, die mit Targets zusammenwirken, wobei zwei erdfreie Ausgänge der Wechselstromquelle mit je einer ein Target tragenden Kathode verbunden sind, wobei beide Kathoden in der Beschichtungskammer nebeneinanderliegend in einem Plasmaraum vorgesehen sind und zum gegenüberliegenden Substrat jeweils etwa den gleichen räumlichen Abstand aufweisen. Der Effektivwert der Entladespannung wird dabei von einer über eine Leitung an die Kathode angeschlossenen Spannungseffektivwerterfassung gemessen und als Gleichspannung einem Regler über eine Leitung zugeführt, der über ein Regelventil den Reaktivgasfluß vom Behälter in die Verteilerleitung so steuert, daß die gemessene Spannung mit einer Sollspannung übereinstimmt.

Schließlich ist eine Vorrichtung zum Beschichten eines Substrats, insbesondere mit nichtleitenden Schichten von elektrisch leitfähigen Targets in reaktiver Atmosphäre bekannt (DE 42 04 999), bestehend aus einer Stromquelle, die mit in einer evakuierbaren Beschichtungskammer angeordneten, Magnete einschließenden Kathoden verbunden ist, die elektrisch mit den Targets zusammenwirken, wobei zwei elektrisch voneinander und von der Sputterkammer getrennte Anoden angeordnet sind, die in einer Ebene zwischen den Kathoden und dem Substrat vorgesehen sind, wobei die beiden Ausgänge der Sekundärwicklung eines mit einem Mittelfrequenzgenerator verbundenen Transformators jeweils an eine Kathode über Versorgungsleitungen angeschlossen sind, wobei die erste und die zweite Versorgungsleitung über eine Zweigleitung untereinander verbunden sind, in die ein Schwingkreis, vorzugsweise eine Spule und ein Kondensator, eingeschaltet sind, und wobei jede der beiden Versorgungsleitungen jeweils sowohl über ein das Gleichspannungspotential gegenüber Erde einstellendes erstes elektrisches Glied mit der Beschichtungskammer als auch über ein entsprechendes zweites elektrisches Glied mit der jeweiligen Anode und über jeweils eine Zweigleitung mit eingeschaltetem Kondensator mit der Beschichtungskammer verbunden ist und wobei eine Drosselspule in den den Schwingkreis mit dem zweiten Sekundäranschluß verbindenen Abschnitt der ersten Versorgungsleitung eingeschaltet ist.

Während die bekannten Vorrichtungen sich damit befassen, das "Arcing", d.h. die Bildung unerwünschter Lichtbögen zu verhindern und die Oberfläche der Targets vor der Bildung isolierender Schichten zu bewahren, soll der Gegenstand der vorliegenden Erfindung nicht nur die Langzeitstabilität und die Depositionsrate des Sputterprozesses erhöhen, sondern auch eine hohe Targetausnutzung und Gleichmäßigkeit gewährleisten.

Gemäß der vorliegenden Erfindung wird diese Aufgabe dadurch gelöst, daß jede der beiden Magnetron-Kathoden in einem eigenen Abteil innerhalb der Vakuumkammer angeordnet ist und beide Abteile über Spalte oder Öffnungen in ihren Trennwänden mit einem dritten Abteil verbunden sind, wobei im dritten Abteil eine Dioden-Kathode mit Sputtertarget vorgesehen ist, die über eine Leitung an eine eigene Gleichstrom-Versorgung angeschlossen ist, und wobei in den Raum zwischen Diodenkathode und dem dieser gegenüberliegenden Substrat Gasleitungen einmünden, über die das Prozeßgas in diesen Bereich zwischen dem Target der Dioden-Kathode und dem Substrat einlaßbar ist.

Weitere Einzelheiten und Merkmale sind in den Patentansprüchen näher erläutert und gekennzeichnet.

Die Erfindung läßt die verschiedensten Ausführungsmöglichkeiten zu; drei davon sind in den anliegenden Zeichnungen schematisch dargestellt.

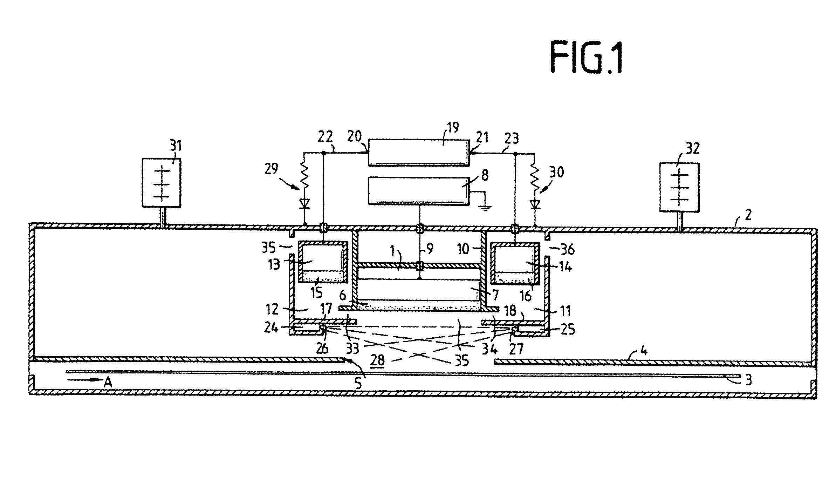

Die in Figur 1 dargestellte Vorrichtung besteht aus einer Vakuumkammer 2, in der ein Substrat 3 längsverschiebbar gehalten und geführt ist, wobei oberhalb des Substrats 3 eine Blende 4 mit Blendenöffnung 5 vorgesehen ist, die den Niederschlag des vom Target 6 der Kathode 7 abgestäubten Materials auf der Oberfläche des sich in Pfeilrichtung A bewegenden Substrats 3 gestattet. Die Kathode 7 ist über eine Leitung 9 an eine Gleichstromquelle 8 angeschlossen und ist im übrigen mit Hilfe eines topfförmigen Gehäuses 10 von den Abteilen 11 und 12 abgetrennt, in denen jeweils Kathoden 13,14 angeordnet sind, deren Targets 15,16 jeweils auf das untere Wandteil 17 bzw. 18 der Abteile 11,12 ausgerichtet sind. Die Kathoden 13,14 sind jeweils an einen Pol 20 bzw. 21 der Wechselstromquelle 19 über jeweils einen Stromleiter 22,23 angeschlossen. Unterhalb der Bodenteile 17,18 der Abteile 11,12 befinden sich Gaszufuhrleitungen 24,25 mit Düsen 26,27, über die Prozeßgas in den Zwischenraum 28, der von dem Target 6 einerseits und dem Substrat 3 andererseits begrenzt wird, einströmt.

Es sei noch erwähnt, daß als Zündhilfe die elektrischen Stromleiter 22,23 jeweils über einen Widerstand mit Diode 29,30 mit der Vakuumkammer 2 verbunden sind und die Vakuumkammer 2 außerdem an Vakuumpumpen 31,32 angeschlossen ist, und daß in der Ebene des Targets 6 der Dioden-Kathode 7 Spalte oder Öffnungen 33 bzw. 34 vorgesehen sind, die die Abteile 11,12 mit dem Raum 35 unmittelbar vor dem Target 6 verbinden, so daß das von den Magnetron-Kathoden 13,14 erzeugte Plasma gleichmäßig vor dem Target der Dioden-Kathode (der Kathode ohne Magnetanordnung) 7 im Raum 35 brennt. Weitere Öffnungen 35,36 in den Außenwänden der Abteile 11,12 ermöglichen das rasche Evakuieren dieser Abteile.

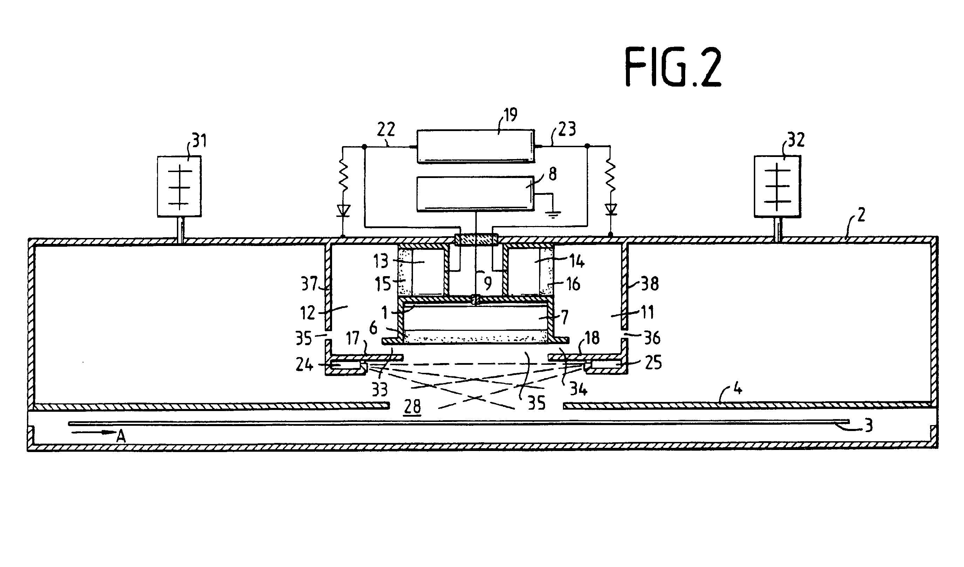

Die Ausführungsform gemäß Figur 2 unterscheidet sich von derjenigen nach Figur 1 dadurch, daß die Magnetron-Kathoden 13,14 so ausgerichtet sind, daß ihre Targets 15,16 den Außenwänden 37,38 der Abteile 11,12 gegenüberliegen.

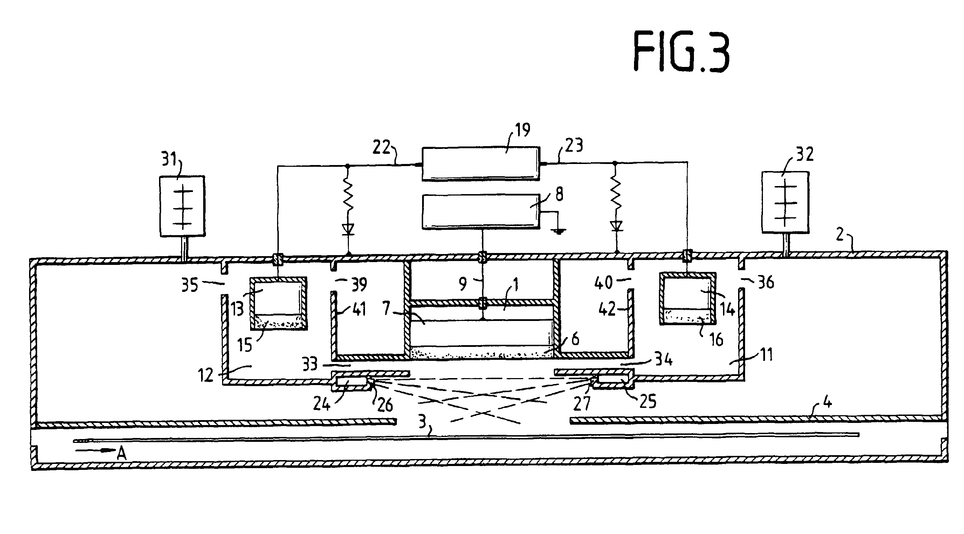

Die Ausführungsform gemäß Figur 3 unterscheidet sich von derjenigen nach Figur 1 im Wesentlichen dadurch, daß die Abteile 11,12 über rückwärtige Öffnungen oder Kanäle 39,40 in den Wänden 41,42, die einander zugekehrt sind, miteinander in Verbindung stehen.

Ein Vorteil der erfindungsgemäßen Anordnung im Vergleich zu bekannten Anordnungen ist, daß mit Einsatz der auseinandergerückten Magnetron-Kathoden als zusätzliche Plasmaquelle (Elektronen und Ionen) die Plasmadichte direkt vor der genannten Dioden-Kathode wesentlich höher ist als in bekannten Anordnungen. Damit erreicht man:
1. höhere Depositionsrate,
2. gute Gleichmäßigkeit,
3. hohe Targetausnutzung,
4. hohe Langzeitstabilität,
5. großflächig statisches Sputtern mit guter Gleichmäßigkeit.

Die TwinMag-Kathoden 13,14 (Anordnung von zwei Magnetron-Kathoden) sind mit einem Target 15,16 aus Kohlenstoff bestückt, um eine möglichst geringe Sputterrate zu erhalten, weil bei dieser Anordnung der Sputtereffekt der Magnetronentladung unerwünscht ist. Die Dioden-Kathode 7 ist mit einem Target 6 belegt, das das zu sputternde Material enthält. Alle drei Kathoden befinden sich in einer Vakuumkammer 2. Die drei Kathoden haben jeweils eine Dunkelraumabschirmung. Die Dunkelraumabschirmungen der TwinMag-Kathoden sind floatend, während die Dunkelraumabschirmung der Dioden-Kathode geerdet ist. Die Dioden-Kathode 7 wird an eine Gleichspannungsstromversorgung angeschlossen, wobei der Pluspol der Stromversorgung mit der Vakuumkammer verbunden ist, d.h. geerdet ist. Die Wechselspannung (Netzwechselspannung oder Mittelfrequenz oder eine Frequenz dazwischen) wird an die beiden TwinMag-Kathoden 13,14 angelegt. Durch die Wechselspannung entwickelt sich ein Plasmaband zwischen beiden Kathoden 13,14. Die Ausbreitung des Plasmabandes wird durch die Abschirmung der Anordnung begrenzt, so daß das Plasmaband über das Target der Dioden-Kathode streicht. Der Gaseinlaß befindet sich unterhalb der genannten Abschirmung, so daß die Targets nicht direkt durch einen Gasstrahl getroffen werden können.

### Bezugszeichenliste

- 1: Abteil
- 2: Vakuumkammer
- 3: Substrat
- 4: Blende
- 5: Blendenöffnung
- 6: Target
- 7: Kathode
- 8: Gleichstromquelle
- 9: Leitung, Stromleiter
- 10: topfförmiges Gehäuse
- 11: Abteil
- 12: Abteil
- 13: Kathode
- 14: Kathode
- 15: Target
- 16: Target
- 17: Wandteil
- 18: Wandteil
- 19: Wechselstromquelle
- 20: Pol, Anschluß
- 21: Pol, Anschluß
- 22: Stromleiter
- 23: Stromleiter
- 24: Gas-Zuleitung
- 25: Gas-Zuleitung
- 26: Düse
- 27: Düse
- 28: Zwischenraum
- 29: Widerstand mit Diode
- 30: Widerstand mit Diode
- 31: Vakuumpumpe
- 32: Vakuumpumpe
- 33: Spalt, Schlitz, Öffnung
- 34: Spalt, Schlitz, Öffnung
- 35: Öffnung, Durchbruch
- 36: Öffnung, Durchbruch
- 37: Außenwand
- 38: Außenwand
- 39: Kanal
- 40: Kanal
- 41: Wandteil
- 42: Wandteil

## Patentansprüche

1. Vorrichtung zum Beschichten eines Substrats (3) von elektrisch leitfähigen Targets (15,16), umfassend eine Wechselstromquelle (19), die mit zwei Magnetron-Kathoden (13,14) verbunden ist, die elektrisch mit den Targets (15,16) zusammenwirken, wobei der eine Pol (20) der Wechselstromquelle (19) an die eine Kathode (13) und der andere Pol (21) an die andere Kathode (14) über Versorgungsleitungen (22,23) angeschlossen ist, **dadurch gekennzeichnet, daß** jede der beiden Magnetron-Kathoden (13,14) in einem eigenen Abteil (11,12) innerhalb der Vakuumkammer (2) angeordnet ist und beide Abteile (11,12) über Spalte (33,34) oder Öffnungen in ihren Trennwänden mit einem dritten Abteil (1) oder mit einem Bereich (35) unmittelbar vor diesem dritten Abteil (1) verbunden sind, wobei im dritten Abteil (1) eine Dioden-Kathode (7) mit Sputtertarget (6) vorgesehen ist, die über eine Leitung (9) an eine eigene Gleichstrom-Versorgung (8) angeschlossen ist, und wobei in den Raum (28) zwischen Diodenkathode (7) und der dieser gegenüberliegend angeordneten Substratebene (3) Gasleitungen (24,25) einmünden, über die das Prozeßgas in diesen Bereich (28) zwischen dem Target (6) der Dioden-Kathode (7) und dem Substrat (3) einlaßbar ist.

2. Vorrichtung nach Anspruch 1, weiter **dadurch gekennzeichnet, daß** die Magnetron-Kathoden (13, 14) so ausgerichtet sind, daß die Ebene ihrer Targets (15,16) sich parallel zu den der Substratebene gegenüberliegenden Bodenteilen (17, 18) erstreckt oder daß die Ebenen ihres Targets (15,16) sich parallel zu den die Abteile (11, 12) nach außen zu begrenzenden Seitenwänden (37,38) erstrecken.

3. Vorrichtung nach den Ansprüchen 1 und 2, weiter **dadurch gekennzeichnet, daß** die beiden die Magnetron-Kathoden (13,14) enthaltenden Abteile (11,12) von der Vakuumkammer (2) umschlossen sind und sich die Bodenteile (17,18) der Abteile (11,12) in einer Ebene erstrecken, die parallel der Ebene des Targets (6) der Dioden-Kathode (7) und parallel der Substratebene (3) verläuft und die beiden Schlitze oder Öffnungen (33,34) für den Austritt des Plasmastroms sich diametral gegenüberliegend in den einander zugekehrten Seitenwänden (41,42) der Abteile und in einer Ebene unterhalb der Ebene des Targets (6) der Dioden-Kathode (7) befinden.

## Claims

1. Apparatus for coating a substrate (3) from electrically conductive targets (15, 16), comprising an alternating current power source (19) connected with two magnetron cathodes (13, 14) that co-operate electrically with the targets (15, 16), the one pole (20) of the alternating current source (19) being connected to the one cathode (13) and the other pole (21) to the other cathode (14) via supply lines (22, 23), **characterised in that** each of the two magnetron cathodes (13, 14) is arranged in its own compartment (11, 12) within the vacuum chamber (2) and the two compartments (11, 12) are connected via gaps (33, 34) or openings in their partition walls with a third compartment (1) or with an area (25) immediately in front of this third compartment (1), where in the third compartment (1) is arranged a diode cathode (7) with sputter target (6) that is connected via a line (9) to its own direct current source (8), and where in the space (28) between the diode cathode (7) and the substrate plane (3) arranged opposite this open gas lines (24, 25) via which the process gas can be introduced into this area (28) between the target (6) of the diode cathode (7) and the substrate (3).

2. Apparatus according to claim 1, further **characterised in that** the magnetron cathodes (13, 14) are aligned such that the plane of their targets (15, 16) extends parallel to the floor parts (17, 18) opposite the substrate plane or that the planes of their targets (15, 16) are parallel to the side walls (37, 48) limiting the compartments (11, 12) to the outside.

3. Apparatus according to claims 1 and 2, further **characterised in that** the two compartments (11, 12) containing the magnetron cathodes (13, 14) are surrounded by the vacuum chamber (2) and the floor parts (17, 18) of the compartments (11, 12) extend in a plane which runs parallel to the plane of the targets (6) of the diode cathode (7) and parallel to the substrate plane (3) and the two slots or openings (33, 34) for outlet of the plasma current are diametrically opposed in the mutually facing side walls (41, 42) of the compartments and in a plane below the plane of the target (6) of the diode cathode (7).

## Revendications

1. Dispositif de revêtement d'un substrat (3) par des cibles (15, 16) électriquement conductrices, ledit dispositif comportant une source de courant alternatif (19) qui est reliée à deux cathodes de magnétron (13, 14) qui coopèrent électriquement avec les cibles (15, 16), un pôle (20) de la source de courant alternatif (19) étant raccordé à une cathode (13) et l'autre pôle (21) étant raccordé à l'autre cathode (14) par des lignes d'alimentation (22, 23), **caractérisé en ce que** chacune des deux cathodes de magnétron (13, 14) est disposée dans un propre compartiment (11, 12) à l'intérieur de la chambre à dépression (2) et les deux compartiments (11, 12) sont reliés par des fentes (33, 34) ou des ouvertures, ménagées dans leur paroi de séparation, à un troisième compartiment (1) ou à une région (35) se trouvant juste en avant de ce troisième compartiment (1), une cathode de diode (7) dotée d'une cible de pulvérisation (6) étant placée dans le troisième compartiment (1) et étant raccordée par une ligne (9) à une alimentation propre en courant continu (8), et des conduites de gaz (24, 25) débouchant dans l'espace (28) situé entre la cathode de diode (7) et le plan de substrat (3) situé en face de cette cathode de diode et permettant d'introduire le gaz de traitement dans cette région (28) située entre la cible (6) de la cathode de diode (7) et le substrat (3).

2. Dispositif selon la revendication 1, **caractérisé en outre en ce que** les cathodes de magnétron (13, 14) sont orientées de telle sorte que les plans de leurs cibles (15, 16) s'étendent parallèlement aux pièces de fond (17, 18) situées en face du plan de substrat ou **en ce que** les plans de leurs cibles (15, 16) s'étendent parallèlement aux parois latérales (37, 38) destinées à limiter vers l'extérieur les compartiments (11, 12).

3. Dispositif selon les revendications 1 et 2, **caractérisé en outre en ce que** les deux compartiments (11, 12), contenant les cathodes de magnétron (13, 14), sont entourés par une chambre à dépression (2), et **en ce que** les pièces de fond (17, 18) des compartiments (11, 12) s'étendent dans un plan qui est parallèle au plan de la cible (6) de la cathode de diode (7) et parallèle au plan de substrat (3), et les deux fentes ou ouvertures (33, 34) destinées à la sortie du flux de plasma sont ménagées, en étant diamétralement opposées, dans les parois latérales (41, 42) des compartiments et se trouvent dans un plan situé au-dessous du plan de la cible (6) de la cathode de diode (7).
